Europäisches Patentamt

European Patent Office

Office européen des brevets

(19)

(11) Veröffentlichungsnummer: **0 144 682**
**B1**

(12) # EUROPÄISCHE PATENTSCHRIFT

(45) Veröffentlichungstag der Patentschrift:
09.08.89

(21) Anmeldenummer: 84112865.5

(22) Anmeldetag: 25.10.84

(51) Int. Cl.⁴: **G 01 R 1/073**

(54) Adapter für ein Leiterplattenprüfgerät.

(30) Priorität: 07.11.83 DE 3340184

(43) Veröffentlichungstag der Anmeldung:
19.06.85 Patentblatt 85/25

(45) Bekanntmachung des Hinweises auf die Patenterteilung: 09.08.89 Patentblatt 89/32

(84) Benannte Vertragsstaaten:
AT BE CH DE FR GB IT LI LU NL SE

(56) Entgegenhaltungen:
US–A– 3 906 363

(73) Patentinhaber: Maelzer, Martin
Hagenburger Strasse 26
D-3050 Wunstorf (DE)

Luther, Erich
Hagenburger Strasse 26
D-3050 Wunstorf (DE)

(72) Erfinder: Dehmel, Rüdiger
Ringstrasse 22a
D-3050 Wunstorf (DE)
Erfinder: Maelzer, Martin
Hagenburger Strasse 26
D-3050 Wunstorf (DE)
Erfinder: Luther, Erich
Hagenburger Strasse 26
D-3050 Wunstorf (DE)
Erfinder: Higgen, Hans Hermann
Am Bückeberg 7
D-3060 Stadthagen (DE)

(74) Vertreter: Schmidt-Evers, Jürgen, Dipl.-Ing. et al
Patentanwälte Dipl.-Ing. H. Mitscherlich Dipl.-Ing. K.
Gunschmann Dipl.-Ing. Dr.rer.nat. W. Körber Dipl.-
Ing. J. Schmidt-Evers Dipl.-Ing. W. Melzer Steinsdorfstrasse 10
D-8000 München 22 (DE)

EP 0 144 682 B1

**Beschreibung**

Die Erfindung bezieht sich auf einen Adapter nach dem Oberbegriff des Anspruchs 1.

Ein Adapter dieser Bauart ist in der europäischen patentanmeldung EP-A-0 026 824 beschrieben und dargestellt.

Durch diesen Stand der Technik ist es bereits bekannt, zur Anpassung außer Raster angeordneter Prüfpunkte der zu prüfenden Leiterplatte an im Raster angeordnete Prüfkontakte, einen Adapter zu verwenden, der ihn durchfassende Adapterstifte zur Verbindung der Prüfpunkte mit den zugeordneten Prüfkontakten enthält. Bei einem sogenannten geladenen Adapter durchfassen die Adapterstifte zu ihrer Halterung Führungsplatten mit in und außer Raster angeordneten Führungslöchern. Beim Laden des Adapters ist es somit erforderlich, die Adapterstifte in außer Flucht miteinander stehende Führungslöcher einzuführen. Beim bekannten Adapter ist das Einführen in vorbestimmten Positionen selbst bei gefühlvoller und somit durch Handarbeit bedingter Einführung unbestimmt, weil das Maß der Ausbiegung der Adapterstifte nicht kontrollierbar ist.

Der Erfindung liegt die Aufgabe zugrunde, einen Adapter der vorliegenden Bauart zu schaffen, bei dem das Laden bzw. Entladen einfacher ist.

Diese Aufgabe wird durch eine Ausgestaltung gemäß Anspruch 1 gelöst.

Bei der erfindungsgemäßen Ausgestaltung wird zum einen durch das vorgegebene Spiel, mit dem die Adapterstifte die dritte Führungsplatte durchfassen, und zum anderen durch das Verschieben der dritten Führungsplatte ein Hin- und Herlenken der Adapterstifte ermöglicht, wobei die Auslenkungsweite durch das Spiel vorgegeben und durch ein Verschieben der dritten Führungsplatte vergrößerbar ist. Aufgrund dieser Ausgestaltung können die Adapterstifte erheblich einfacher jeweils in das Führungsloch eingeführt werden, das ihnen am nächsten liegt. Aufgrund des kontrollierbaren Auslenkens der Adapterstifte ermöglicht eine erfindungsgemäße Ausgestaltung auch ein maschinelles Einführen der Adapterstifte in die erste Führungsplatte (Heben der dritten Führungsplatte unter Vibration) oder auch ein halb- oder vollautomatisches Laden.

Da im Betrieb eine geringfügige Längsverschiebung der Adapterstifte aufgrund unterschiedlich hoher Prüfkontakte und Prüfpunkte nicht auszuschließen ist, empfiehlt es sich, die dritte Führungsplatte nach Anspruch 2 in ihrer jeweils vorgeschobenen Stellung zu fixieren. Anderenfalls, nämlich dann, wenn die dritte Führungsplatte wieder zurückgeführt werden würde, würden sich für die Kontaktstifte Reibungsstellen ergeben, die außer Flucht mit dem Raster stehen.

Die Ausgestaltung nach Anspruch 3 ermöglicht ein einfaches und schnelles Auswechseln der ersten Führungsplatte, was zur Entladung des Adapters erforderlich ist.

Gemäß Anspruch 4 ist wenigstens ein Anschlag für die untere Hubendstellung der dritten Führungsplatte vorgesehen, um sie in dieser Stellung unabhängig vom Antrieb halten zu können.

Die Erfindung bezieht sich auch auf ein Verfahren zum Laden des Adapters. Die gegenüber dem eingangs genannten Stand der Technik neuen Verfahrensschritte sind im Anspruch 5 enthalten.

Mit dem erfindungsgemäßen Verfahren läßt sich ein Adapter nicht nur in einfacher Weise sondern auch unter maschineller Durchführung wenigstens des Verfahrensschritts Einführen unter Vibration oder auch vollautomatisch laden. Von besonderer Bedeutung sind dabei das Einführen der Adapterstifte in eine Führung mit vorgegebenem radialem Bewegungsspiel und die progressive Vergrößerung des wirksamen Bewegungsspiels durch das Verschieben dieser Führung. Aufgrund des vorgegebenen radialen Bewegungsspiels können die Adapterstifte radial hin- und herlenken, und zwar um die Führungsstelle in der zweiten Führungsplatte, die sozusagen einen räumlichen Lenkpunkt bildet. Durch das Anlegen einer Vibration lenken die Adapterstifte sehr schnell hin und her, wobei ihre Spitzen Flächen bestreichen. Je näher die dritte Führungsplatte an den vorgenannten Lenkpunkt herangeschoben wird, um so größer ist die Auslenkungsweite an den Spitzen. Aufgrund des erfindungsgemäßen Verfahrens werden die Adapterstifte veranlaßt, sich jeweils das nächstgelegene Führungsloch in der ersten Führungsplatte zu suchen, in das sie dann eintauchen.

Das Verfahren nach Anspruch 6 ist insbesondere im Hinblick auf das Einführen in die erste Führungsplatte bei gleichzeitigem Hin- und Herschwenken der Adapterstifte vorteilhaft, weil eine Halterung der Adapterstifte in dieser Position ihre Hin- und Herschwenkung behindern könnte.

Aufgrund der vergrößerten Schwingungsweite können die Adapterstifte, denen kein Führungsloch zugeordnet ist, eine Schrägstellung einnehmen und in dieser verharren. Da die von der Halteeinrichtung zu erfassenden Enden der Adapterstifte an der Schwenkbewegung teilnehmen und ebenfalls schräg stehen können, empfiehlt sich das Verfahren nach Anspruch 7, um die Adapterstiftenden in einer mittigen Stellung bereitzustellen.

Das Verfahren nach Anspruch 8 umfaßt das Herausziehen der Adapterstifte, denen kein Führungsloch in der ersten Führungsplatte zugeordnet ist. Ein Verbleib dieser Adapterstifte im Adapter wäre zwar denkbar, jedoch würde dies Maßnahmen erfordern, um die weiter aus dem Adapter hervorstehenden Enden dieser Adapterstifte unschädlich zu machen.

Ein maschinelles Laden des Adapters ist zwangsläufig mit einer Maschine verbunden, deren Bauteile Bewegungen ausführen. Ein Verfahren nach Anspruch 9 ist deshalb vorteilhaft, weil die Bewegungsantriebe für den Adapter so angeordnetwerden können, z. B. unterhalb der Maschine, daß das Blickfeld im Bereich des Adapters beim Laden und somit die optische Überwachung des Verfahrensablaufs unbeeinträchtigt bleiben.

Das Verfahren nach Anspruch 10 ermöglicht ein rationelles Arbeiten.

Der Anspruch 11 enthält ein Verfahren zum Entladen eines Adapters. Wie schon das Ladeverfahren umfaßt auch dieses Verfahren einfache Verfahrensschritte, die ein störungsfreies Arbeiten, auch bei maschinell durchgeführten Verfahrensschritten ermöglichen. Das Verfahren ermöglicht es auch, die Adapterstifte, denen keine Führungslöcher beim Laden zugeordnet waren und die wieder herausgezogen wurden, dann in der Haltevorrichtung zu belassen, in den Entladevorgang einzubeziehen und in der Haltevorrichtung wieder bereitzustellen, wenn es sich beim zu entladenden Adapter um den Adapter handelt, der vorher geladen worden ist oder um einen gleichen Adapter.

Das Verfahren nach Anspruch 12 ist aus den gleichen Gründen vorteilhaft, die schon zum Anspruch 9 angeführt wurden.

Der Anspruch 13 umfaßt eine Vorrichtung zur Durchführung der erfindungsgemäßen Verfahren nach den Ansprüchen 5 bis 12. Diese Vorrichtung wird in einfacher Weise gebildet aus einem den Adapter aufnehmenden Träger und einer Haltevorrichtung für die Adapterstifte, wobei einer dieser Teile, bevorzugt der Träger, in Richtung auf den anderen Teil, insbesondere senkrecht, verschiebbar ist. Der Vorrichtung ist ein Vibrator zugeordnet, der bevorzugt auf die dritte Führungsplatte einwirkt und das schnelle Hin- und Herlenken der Adapterstifte beim Laden veranlaßt.

Neben der vorgenannten Funktion, das Einführen der Adapterstifte zu erleichtern, ermöglicht die Ausrichtvorrichtung nach Anspruch 14 ein Ausrichten der durch die Verdickungen gebildeten Adapterstiftköpfe, und zwar der Köpfe der Adapterstifte, denen kein Führungsloch in der dritten Führungsplatte zugeordnet ist, und die deshalb nach dem Verfahrensschritt Einführen in die erste Führungsplatte bei gleichzeitiger Hin- und Herschwenkung der Adapterstifte schräg stehen bleiben können. Darüberhinaus kann die Ausrichtvorrichtung auch eine Richtfunktion beim Einführen der Adapterstifte in den Adapter ausführen.

Die Ausbildung nach Anspruch 15 ermöglicht es, die Adapterstifte zum Zweck des Herausziehens soweit aus dem Adapterherauszurücken, daß die Adapterstiftköpfe sicher von der Haltevorrichtung erfaßt werden können.

Gemäß Anspruch 16 wird eine einfach und kompakt zu bauende Haltevorrichtung vorgeschlagen, die eine Klemmwirkung auf die Adapterstifte ausüben kann.

Es empfiehlt sich im Sinne des Anspruchs 17 Zylinder-Kolbenantriebe mit den bekannten Vorteilen für die gemäß den Ansprüchen 13 bis 16 erforderlichen Bewegungen vorzusehen.

Zum Zwecke des bevorzugt vollautomatischen Betriebs umfaßt die Vorrichtung gemäß Anspruch 18 eine Druckluftquelle und eine elektromechanische Steuereinheit zur Steuerung der Zylinder-Kolbenantriebe und des Vibrators.

Nachfolgend werden zwei Ausführungsbeispiele der Erfindung anhand einer vereinfachten Zeichnung näher beschrieben.

Es zeigen

Figur 1 einen Teilschnitt durch ein Gerät zum Prüfen von Leiterplatten, wobei der Teilschnitt senkrecht zur im Gerät aufgenommenen Leiterplatte verläuft,

Figur 2 eine Vorrichtung zum Laden bzw. Entladen eines Adapters im Querschnitt,

Figur 3 bis 11 der Figur 3 entsprechende Ansichten des Gerätes in verschiedenen Arbeitsstellungen,

Figur 12 die Einzelheit X in Figur 1 in vergrößerter Darstellung,

Figur 13 ein zweites Ausführungsbeispiel eines Adapters,

Figur 14 eine Draufsicht auf den Adapter nach Figur 13.

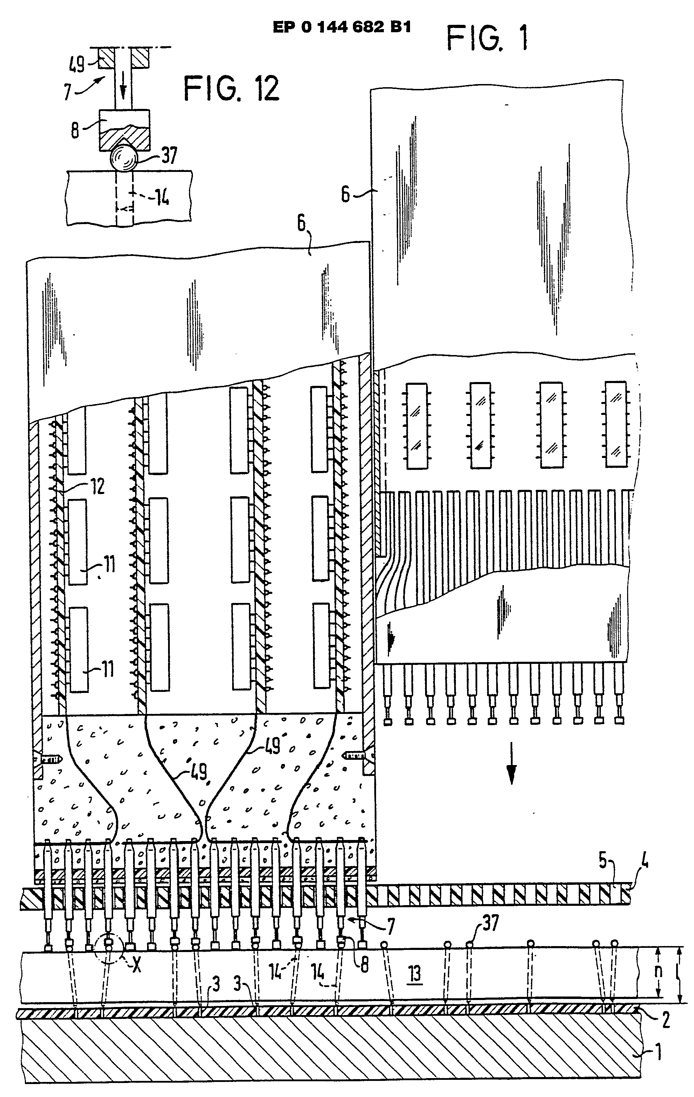

In der Figur 1 ist eine Aufnahmeplatte des im ganzen nicht dargestellten Gerätes zum Prüfen von Leiterplatten mit 1 bezeichnet. Auf dieser Aufnahmeplatte befindet sich eine Leiterplatte 2 mit Prüfpunkten 3. Oberhalb der zu prüfenden Leiterplatte 2 befindet sich eine Rasterlochplatte 4, deren Löcher 5 im Raster angeordnet sind, und zwei in Richtung auf die Leiterplatte 2 und zurück bewegliche Moduln 6, die an ihren unteren Stirnseiten mit Prüfkontakten 7 in Form von Stiften versehen sind, welche in der herabgefahrenen position eines Moduls 6 die Löcher 5 in der Rasterlochplatte 4 durchgreifen. Die Prüfkontakte 7 tragen teleskopisch ein- und ausfahrbare Prüfkontaktköpfe 8, die in Richtung auf ihre äußere Endstellung durch eine nicht dargestellte Feder vorgespannt sind.

Die Prüfkontakte 7 sind in den Moduln 6 durch Vergießen befestigt und stehen durch elektrische Leitungen 49 mit IC-Chips 11 tragenden Leiterplatten 12 in Verbindung, die innerhalb der Moduln 6 angeordnet sind und in ihrer Gesamtheit mit den Leiterplatten 12, den IC-Chips 11 und gegebenenfalls weiteren Bauelementen eine den Prüfkontakten 7 zugeordnete Teilschaltermatrix bilden.

Auf der Leiterplatte 2 befindet sich ein Rasteranpassungsadapter 13 der eine Vielzahl ihn durchfassender Adapterstifte 14 aufweist, die die im Raster angeordneten Prüfkontakte 7 mit den außer Raster angeordneten Prüfpunkten 3 verbinden. Die Adapterstifte 14 liegen deshalb nicht in der jeweiligen Flucht mit den Prüfkontakten, sondern erstrecken sich schräg durch den Adapter 13 wobei sie mit beiden Enden aus dem Adapter 13 hervorragen und gegenüber der Ober- und Unterseite erhabene Kontaktstellen bilden.

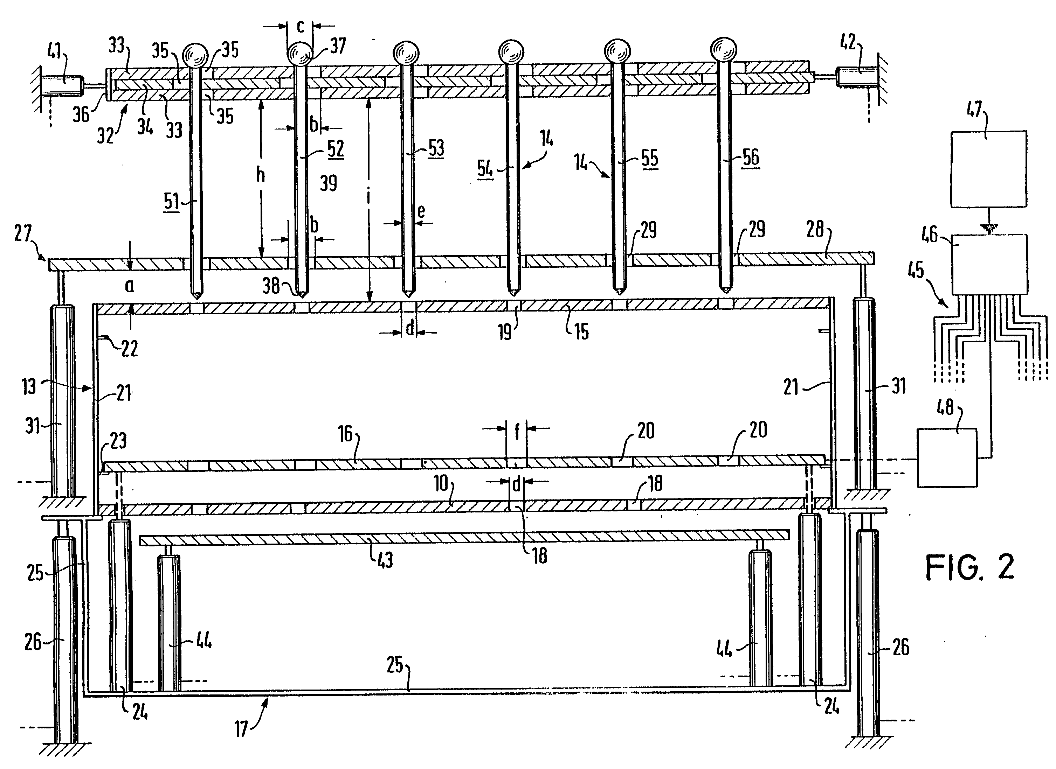

In der Fig. 2 ist der Adapter 13 zwar vergrößert, aber ebenfalls mit einer allgemein mit 17 bezeichneten Vorrichtung zum Laden bzw. Entladen schematisch dargestellt. Er weist eine erste horizontale Führungsplatte 10 mit außer Raster angeordneten Führungslöchern 18, eine zweite, in einem Abstand sich oberhalb der ersten erstreckende, horizontale Führungsplatte 15 mit im Raster angeordneten Führungslöchern 19 und eine dritte, sich zwischen den beiden vorgenannten erstreckende Führungsplatte 16 mit ebenfalls im Raster angeordneten Führungslöchern 20 auf. Alle drei Führungsplatten 10, 15, 16 bestehen zwecks Verhinderung von Kurzschlüssen während der Prüfung der Leiterplatten aus nichtleitendem Material. Während die erste und die zweite Führungsplatte 10, 15 mit seitlichen Stirnwänden 21 zu einem Kasten starr verbunden sind, ist die dritte Führungsplatte 16 vertikal zwischen oberen und unteren Anschlägen 22, 23 mittels pneumatischen Zylinder-Kolbenantrieben 24 verschieblich.

Der Adapter 13 steht auf einem Träger 25, der in der vorliegenden schematischen Zeichnung wannenförmig ausgebildet ist. Der Träger 25 ist vertikal durch zwei Zylinder-Kolbenantriebe 26 verschiebbar und bildet die Widerlager für die beiden Zylinder-Kolbenantriebe 24 die die dritte Führungsplatte 16 verschieben können.

Oberhalb der zweiten Führungsplatte erstreckt sich in einem Abstand a eine Ausrichtungsvorrichtung 27 für die in noch zu beschreibender Weise in den Adapter H einzuführenden Adapterstifte 14. Die Ausrichtungsvorrichtung 27 besteht aus einer Ausrichtplatte 28 mit im Raster angeordneten Führungslöchern 29 und zwei Zylinder-Kolbenantrieben 31, mit denen die Ausrichtplatte 30 vertikal verschieblich ist.

In einem Abstand oberhalb der Ausrichtvorrichtung 27 ist eine Haltevorrichtung 32 für die Adapterstifte 14 vorgesehen, die aus drei aufeinanderliegenden Klemmplatten 33, 34 mit (in ihrer Offenstellung) im Raster angeordneten Löchern 35 und zwei Zylinder-Kolbenantrieben 41, 42 besteht, von denen der Zylinderkolbenantrieb 41 durch ein T-Stück 36 zugleich an beiden Klemmplatten 33 angreift und der Zylinder-Kolbenantrieb 42 an der mittleren Klemmplatte 34 angreift. In der Offenstellung der Klemmplatten 33, 34 befinden sich deren Löcher 35 übereinander. Der Durchmesser b der Löcher 35 ist geringfügig größer bemessen, als der Durchmesser c von durch kugelförmige Verdickungen gebildeten Adapterstiftköpfen 37. In der in Fig. 2 dargestellten Position befinden sich die Klemmplatten 33, 34 in ihrer Klemmstellung, sie untergreifen die Adapterstiftköpfe 37. Die Klemmplatten 33, 34 sind in einem solchen Abstand h, i über der Ausrichtplatte 28 und dem Adapter 13 angeordnet, daß die Adapterstiftspitzen 38 die Ausrichtplatte 28 durchfassen und vor den Führungslöchern 19 in der zweiten Führungsplatte 15 stehen. Der Durchmesser b der Führungslöcher 29 in der Ausrichtplatte 28 entspricht dem Durchmesser b der Löcher 35 in den Klemmplatten 33, 34, so daß die Adapterstifte 14 wie folgend beschrieben in den Adapter 13 eingeführt werden können. Während der Durchmesser d der Führungslöcher 18 und 19 in der ersten und zweiten Führungsplatte 10, 15 mit nur einem üblichen Führungsspiel größer bemessen ist als der Durchmesser e der Adapterstiftsschäfte 39, ist der Durchmesser f der Führungslöcher 20 in der dritten Führungsplatte 16 mit deutlichem Spiel größer bemessen. Unterhalb der ersten Führungsplatte 10 befindet sich eine Stiftheberplatte 43, die mittels Zylinder-Kolbenantriebe 44 höhenverstellbar ist.

Vorgenannte Zylinder-Kolbenantriebe werden mit Druckluft betrieben und stehen durch Leitungen 45 und einer vereinfacht dargestellten Steuereinheit 46 mit einer Druckluftquelle 47 in Verbindung.

Der Ladevorrichtung 17 ist auch noch ein andeutungsweise dargestellter Ultraschall-Vibrator 48 zugeordnet, der der dritten Führungsplatte 16 parallel zur Plattenebene gerichtete Schwingungen zu übertragen vermag.

Im folgenden werden anhand der Fig. 2 bis 11 die einzelnen Verfahrensschritte zum Laden und Entladen des Adapters 13 sowie die sich ergebenden Arbeitsstellungen der Ladevorrichtung 17 beschrieben:

Zunächst wird der Adapter 13 in die Ladevorrichtung 17 mittels eines nicht dargestellten Schlittens eingeführt. Die erste Führungsplatte 10 setzt dabei auf den Träger 25 der Ladevorrichtung 17 auf. Die Adapterstifte 51 bis 56 hängen in den gegeneinander verschobenen Klemmplatten 33, 34 (s. Fig. 2).

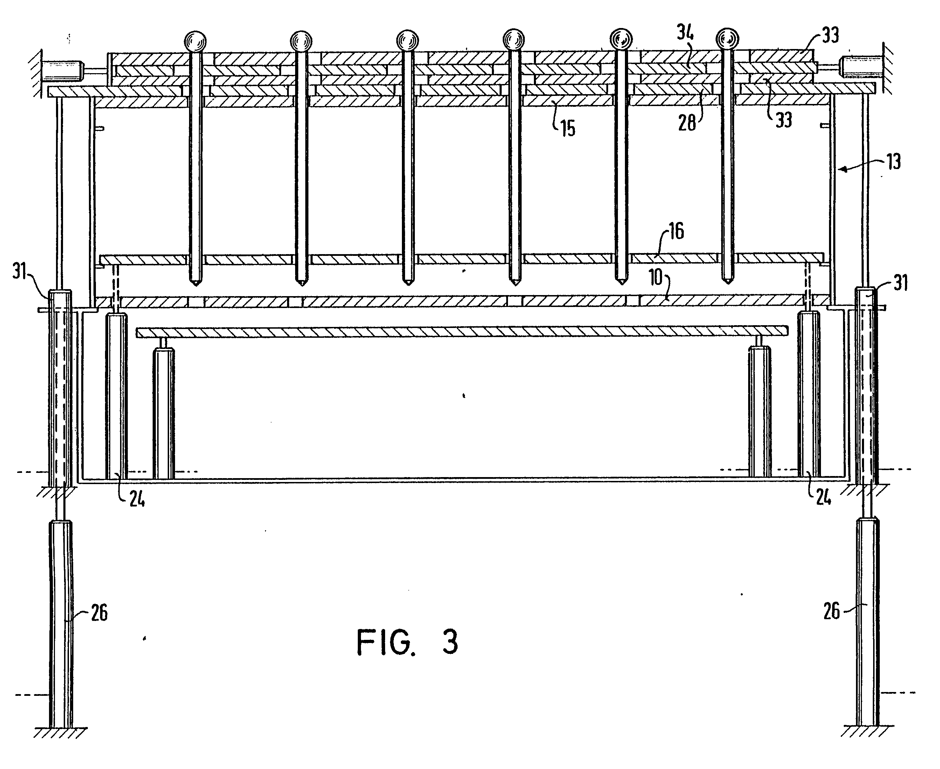

Die Zylinder-Kolbenantriebe 26 werden betätigt und heben die Zylinder-Kolbenantriebe 24 und mit diesen den Adapter 13 an. Gleichzeitig werden die Zylinder-Kolbenantriebe 31 betätigt, die die Ausrichtplatte 28 anheben. Die Ausrichtplatte 28 legt sich dabei an die untere Klemmplatte 33. Der Adapter 13 wird soweit angehoben, daß sich die zweite Führungsplatte 15 an die Ausrichtplatte 28 anlegt (s. Fig. 3).

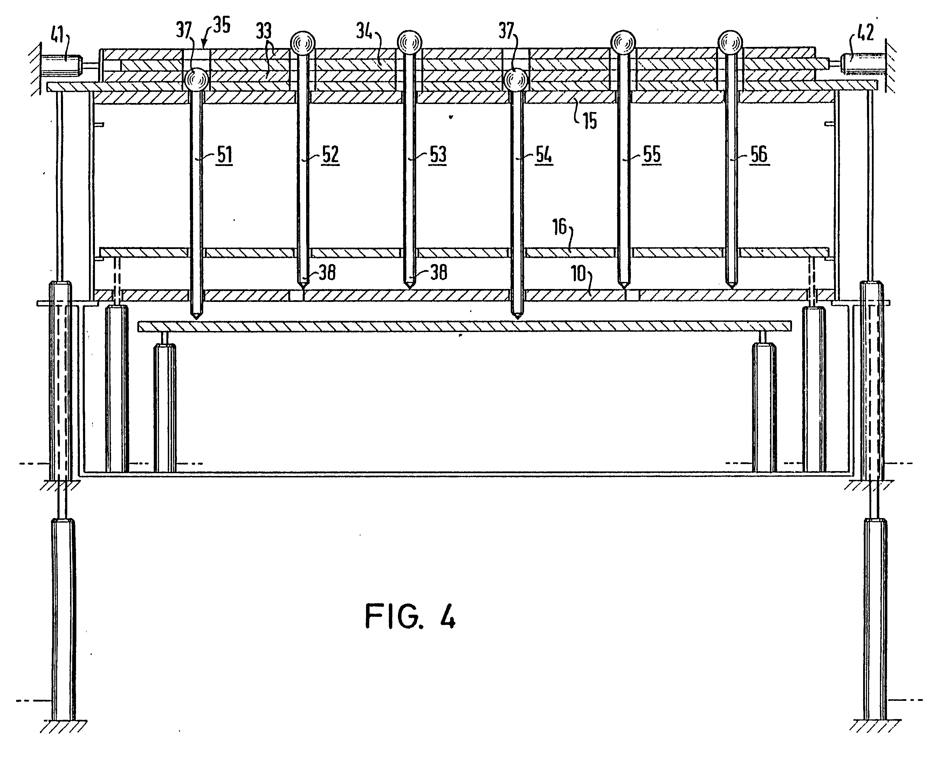

Die Zylinder-Kolbenantriebe 41, 42 werden betätigt, wodurch die Löcher 35 in den Klemmplatten 33, 34 fluchtend zueinander ausgerichtet werden. Dadurch fallen die Adapterstifte 51 bis 56 aus den Löchern 35. Die Adapterstifte 51 und 54 fallen ganz durch, so daß ihre Köpfe 37 auf der zweiten Führungsplatte 15 zu liegen kommen. Die Adapterstifte 52, 53, 55 und 56 stoßen mit ihren Spitzen 38 auf die erste Führungsplatte 10 (s. Fig. 4).

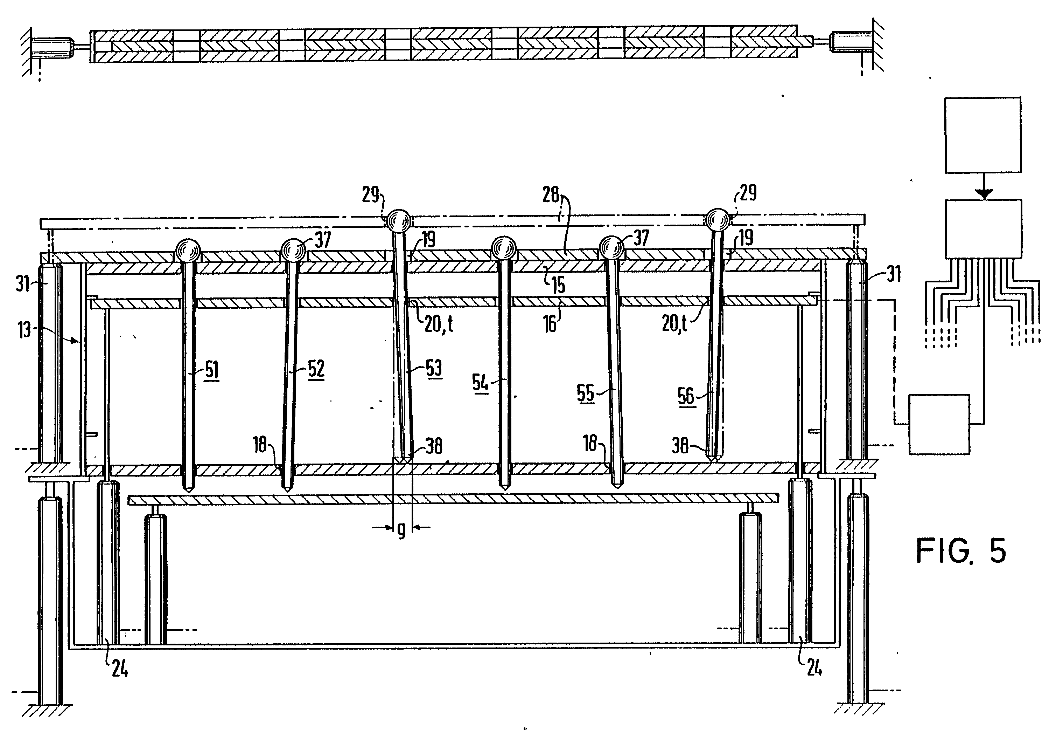

Der Adapter 13 wird wieder in die Ausgangsstellung gemäß Fig. 2 abgesenkt. Die Ausrichtplatte 28 wird soweit abgesenkt, so daß sie auf der zweiten Führungsplatte 15 aufliegt. Es wird der Vibrator 48 eingeschaltet, der die dritte Führungsplatte 16 zum Vibrieren und die Adapterstifte zum Auslenken um ihre Führungsstellen (Führungslöcher 19) bringt. Gleichzeitig wird die dritte Führungsplatte 16 durch Betätigung der Zylinder-Kolbenantriebe 24 langsam angehoben. Die Adapterstifte 52, 53, 55 und 65 erhalten dadurch in den Führungslöchern 20 der dritten Führungsplatte 16 zunehmend Bewegungsspielraum, der eine größere Auslenkweite bewirkt. Während ihrer Auslenkbewegungen finden die Adapterstifte 52 und 55 ihre Führungslöcher 18, und zwar fallen die Adapterstifte zuerst in die am nächsten gelegenen Führungslöcher 18 und zuletzt in die am entferntesten Führungslöcher 18 im Auslenkkreis. Die Köpfe 37 dieser Adapterstifte 52, 55 sitzen dann ebenfalls auf der zweiten Führungsplatte 15 auf. Die Adapterstifte 53 und 56 bleiben mit ihren Spitzen 38 auf der ersten Führungsplatte 10, da sich dort an den entsprechenden Stellen keine Führungslöcher 18 befinden. Sie stellen sich allerdings etwa schräg (s. Fig. 5).

Anschließend wird die Ausrichtplatte 28 durch Betätigung der Zylinder-Kolbenantriebe 31 soweit nach oben verschoben, daß die Köpfe 37 der Adapterstifte 53, 56 von den Führungslöchern 29 der Ausrichtplatte 28 umfaßt werden. Dadurch werden diese Adapterstifte 53, 56 wieder gerade gerückt (s. strichpunktierte Stellung der Ausrichtplatte D in Fig.5).

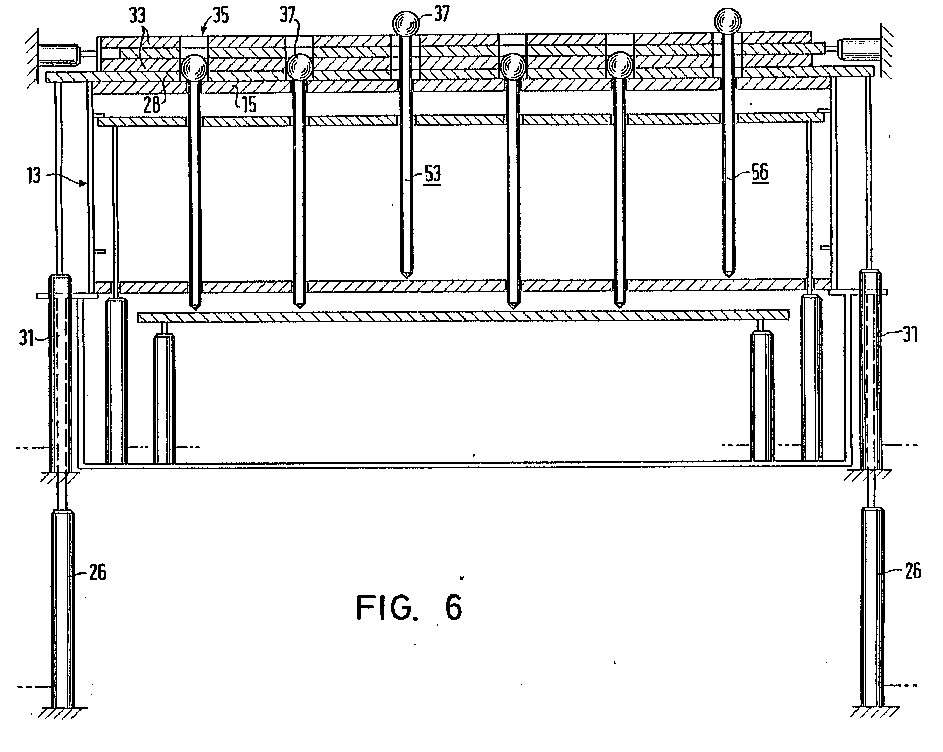

Der nächste Arbeitsschritt wird mit dem Ziel verrichtet, die nicht vollständig eingeführten Adapterstifte 53, 56 aus dem Adapter herauszuziehen. Hierzu wird der Adapter 13 durch Betätigung der Zylinder-Kolbenantriebe 26 nach oben gefahren. Gleichzeitig wird die Ausrichtplatte 28 durch Betätigung der Zylinder-Kolbenantriebe 31 nach oben gefahren. Beides erfolgt so, daß sich die Ausrichtplatte 28 an die untere Klemmplatte 33 anlegt und die zweite Führungsplatte 15 des Adapters 13 an die Ausrichtplatte 28. Die Klemmplatten 33, 34 sind so zueinander ausgerichtet, daß ihre Löcher 35 miteinander fluchten, d. h., daß die Köpfe 37 der Adapterstifte eintauchen können (s. Fig. 6).

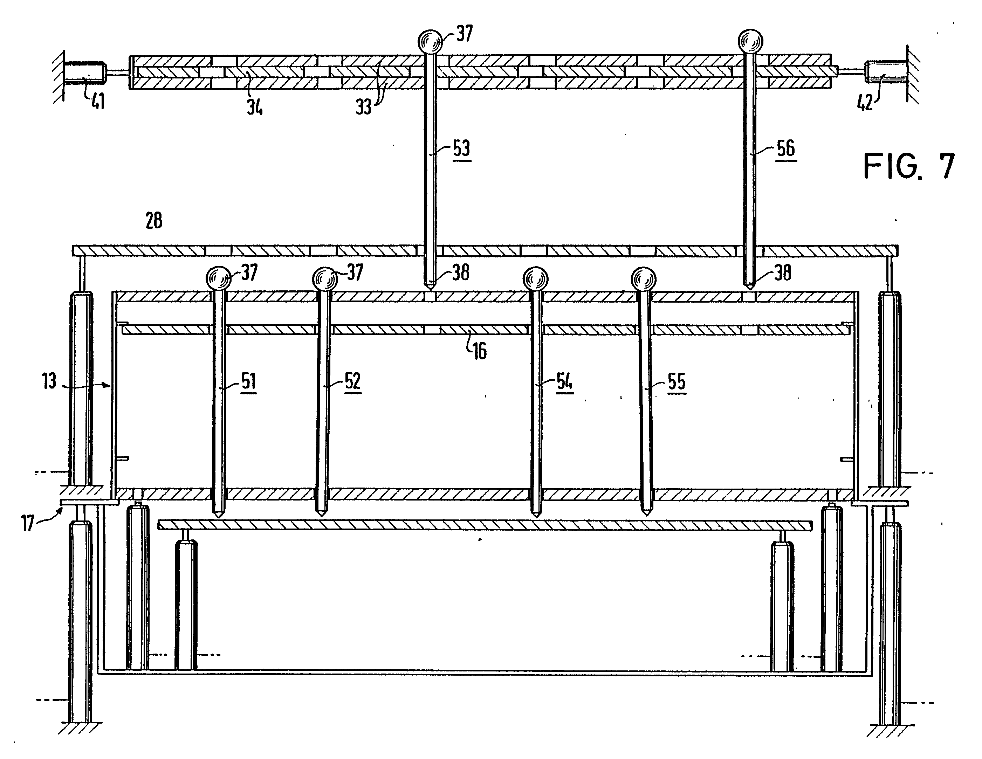

Zur Weiterverfolgung des vorgenannten Zieles werden die Klemmplatten 33, 34 durch Betätigen der Zylinder-Kolbenantriebe 41, 42 verriegelt. Der Adapter 13 und die Ausrichtplatte 28 werden dann wieder in ihre Ausgangsposition zurückgefahren, wobei die Ausrichtplatte 28 in einer Position stehen gelassen wird, in der sie die Köpfe 37 der im Adapter 28 befindlichen Adapterstifte 51, 52, 54 und 55 freigibt und die Spitzen 38 der in den Klemmplatten 33, 34 hängengebliebenen Adapterstifte 53, 56 führt. Gegebenenfalls gleichzeitig werden die dritte Führungsplatte 16 durch eine nicht dargestellte Halterung in ihrer oberen Position fixiert und die Zylinder-Kolbenantriebe 24 betätigt, um deren Kolben aus dem Adapter 13 herauszuziehen. Die Fixierung der dritten Führungsplatte 16 in der oberen Endposition erfolgt, um ein Verschieben der Adapterstifte im Adapterbetrieb nicht durch Reibung an den Lochrändern der dritten Führungsplatte 16, wenn diese sich in ihrer unteren Endstellung befände, zu behindern. Der Adapter 13 ist nunmehr betriebsbereit und wird durch den nicht dargestellten Schlitten aus der Ladevorrichtung 17 entnommen (s. Fig.7).

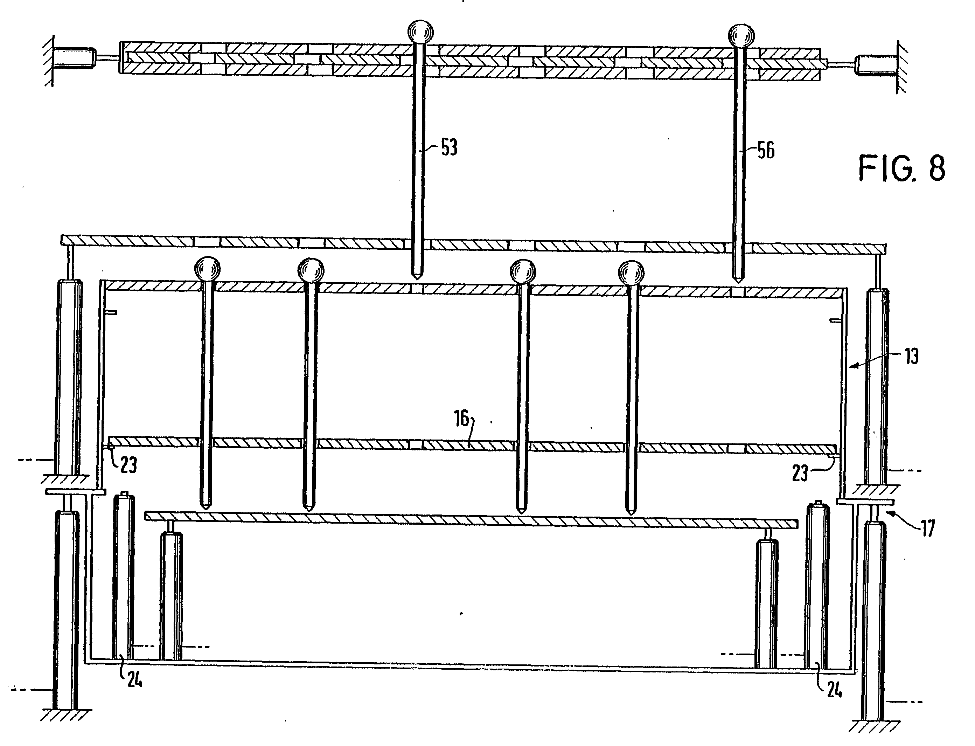

Um einen Adapter 13 wieder zu entladen, muß zunächst seine erste Führungsplatte 10 entfernt werden. Der Adapter 13 wird dann wieder mit dem nicht dargestellten Schlitten in die Ladevorrichtung 17 eingefahren, und die dritte Führungsplatte 16 wird aus ihrer Fixierung gelöst und durch nicht dargestellte Mittel gegen die unteren Anschläge 23 in ihre untere Endstellung gefahren (s. Fig. 8). Die Mittel zur vorgenannten Fixierung und zum Herunterfahren sind nicht erfindungswesentlich und deshalb aus Vereinfachungsgründen nicht dargestellt.

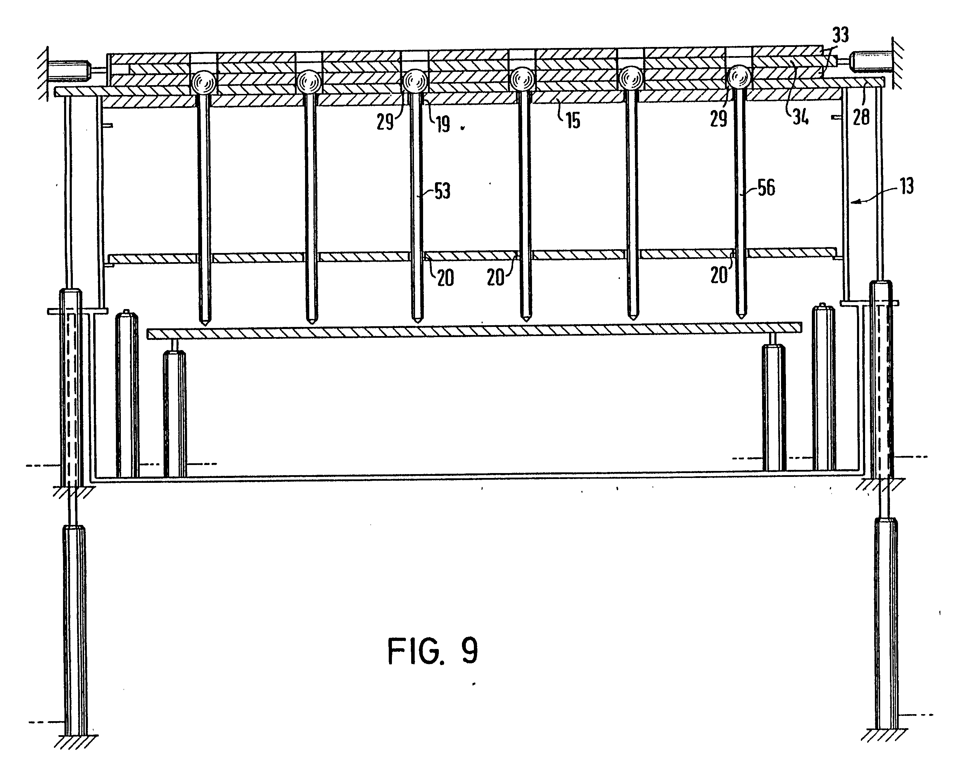

Der Adapter 13 und die Ausrichtplatte 28 werden dann wo weit angehoben und gleichzeitig die Klemmplatten 33, 34 geöffnet, daß die Ausrichtplatte 28 an der unteren Klemmplatte 33 anliegt und die zweite Führungsplatte 15 an der Ausrichtplatte 28. Dabei tauchen die von den Klemmplatten 33, 34 noch gehaltenen Adapterstifte 53 und 56 durch die Führungslöcher 29, 19 und 20 in den Adapter 13 ein (s. Fig. 9).

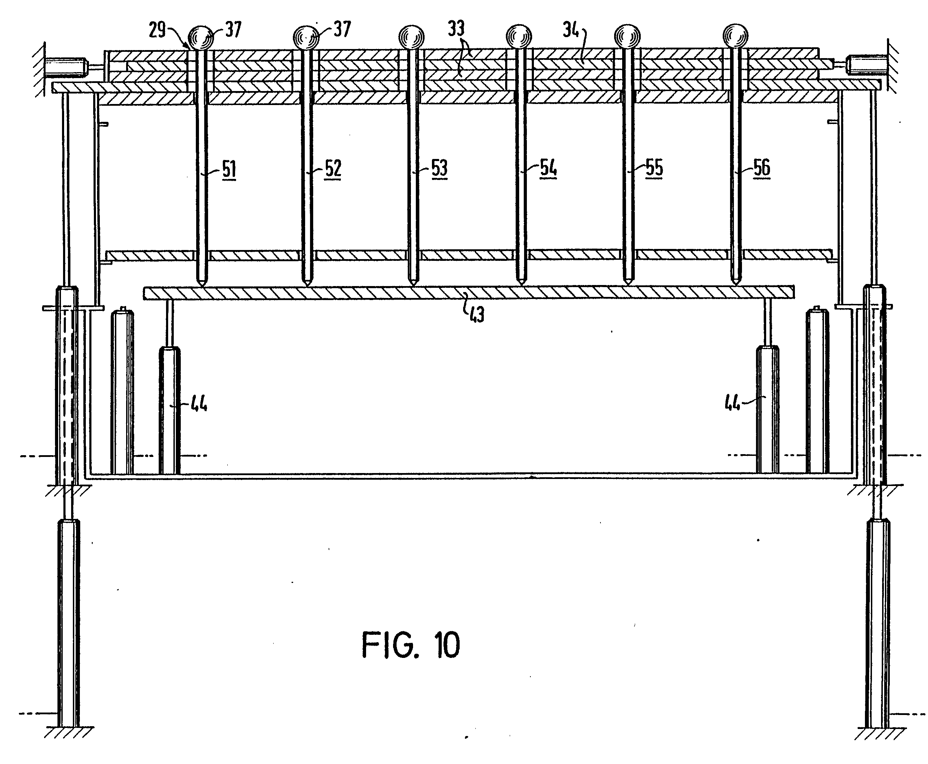

Nunmehr wird die Stiftheberplatte 43 durch Betätigung der Zylinder-Kolbenantriebe 44 nach oben verschoben, wodurch die Köpfe 37 aller Adapterstifte 51 bis 56 durch die fluchtenden Löcher 29 der Klemmplatten 33, 34 hindurchtreten, bis die Köpfe 37 oberhalb der oberen Klemmplatte 33 zu liegen kommen (s. Fig. 10).

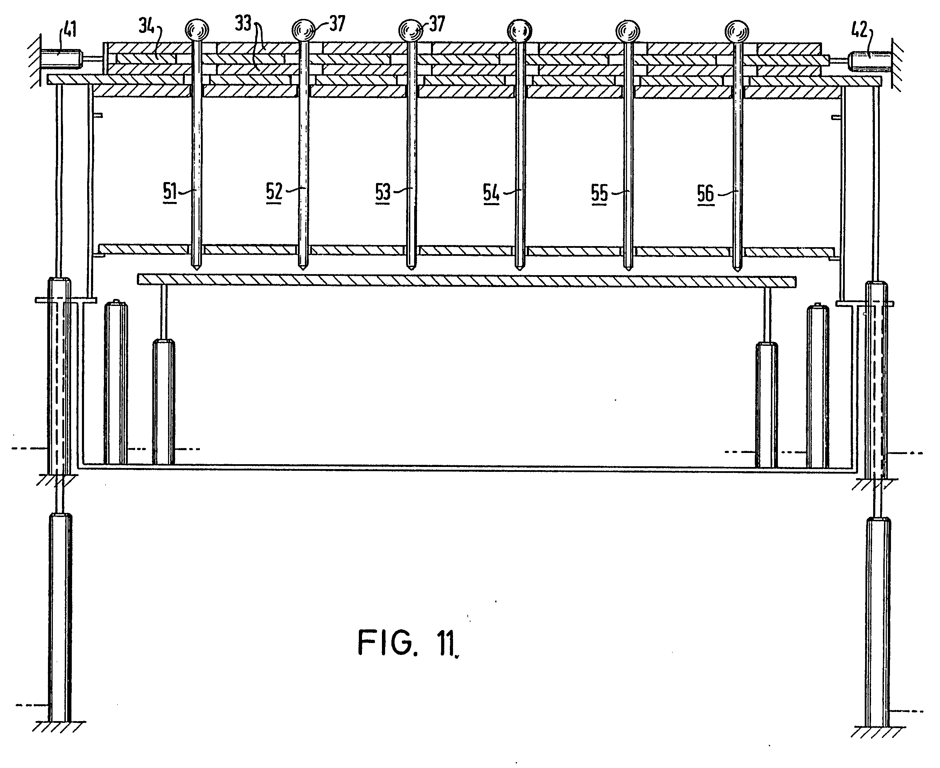

Jetzt werden die Klemmplatten 33, 34 durch Betätigung der Zylinder-Kolbenantriebe 41, 42 wieder gegeneinander verschoben, so daß alle Adapterstifte 51 bis 56 festgehalten werden (s. Fig. 11).

Der letzte Arbeitsschritt besteht darin, die Stiftheberplatte 43, den Adapter 13 und die Ausrichtplatte 28 wieder in die Ausgangsstellung gemäß Fig. 2 abzusenken. Um ihn neu zu laden, muß er wieder mit einer ersten Führungsplatte 10 versehen werden.

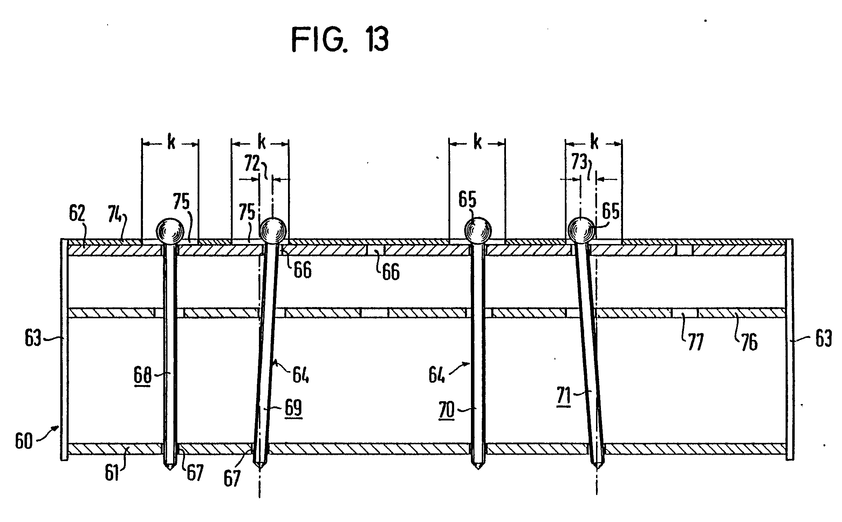

In der Figur 12 Einzelheit X ist das Zusammenwirken der kugelförmigen Adapterstiftköpfe 37 mit den Prüfkontakten 7 bzw. deren Prüfkontaktköpfen 8 dargestellt. Die Prüfkontaktköpfe 8 sind teleskopisch ein- und ausfahrbar in den Prüfkontaktschäften 49 geführt und mittels einer als Pfeil dargestellten Federkraft in Richtung auf ihre ausgeschobene Hubendstellung vorgespannt. Zum Zweck eines verbesserten Flächenkontaktes mit dem kugelförmigen Adapterstiftköpfen sind die Kontaktstiftköpfe auf ihren Kontaktflächen kalotten-förmig ausgenommen.

Das im vorbeschriebenen Ausführungsbeispiel enthaltene Verfahren und die Vorrichtung zum Laden des Adapters sind für den voll- bzw. halbautomatischen Lade- bzw. Entladebetrieb bestimmt. Dies schließt jedoch nicht aus, daß sowohl ein einzelner als auch mehrere Verfahrensschritte manuell durchgeführt werden können.

Dagegen bezieht sich das zweite Ausführungsbeispiel gemäß Figuren 12 und 13 auf einen Adapter, der für das manuelle Laden bestimmt ist. Dieser allgemein mit 60 bezeichnete Adapter besteht ebenfalls aus einer ersten Führungsplatte 61, eine parallel dazu und im Abstand angeordneten zweiten Führungsplatte 62, Stirnwänden 63, die dem Adapter 60 Kastenform geben, und Adapterstiften 64, die den Adapter 60 von oben hängend durchfassen, wobei sie mit kugelförmigen Köpfen 65 auf der zweiten Führungsplatte 62 aufliegen. Wie schon beim ersten Ausführungsbeispiel ist auch beim zweiten die Länge der Adapterstifte 64 größer bemessen, als die Höhe des Adapters 60, so daß sie beiderseits des Adapters 60 erhabene Kontaktstellen bilden.

Auch beim zweiten Ausführungsbeispiel sind die Führungslöcher 66 in der zweiten Führungsplatte 62 im Raster und die Führungslöcher 67 in der ersten Führungsplatte 61 ausser Raster angeordnet. In der Figur 12 läßt sich leicht ausmachen, daß die Adapterstifte 68 und 7 mit dem Raster fluchten, während die Adapterstifte 69 und 71 in und außer Raster liegende Kontaktstellen verbinden. Der Versatz der Kontaktstellen ist im Bereich des Adapterstiftes 69 mit 72 und der Versatz im Bereich des Adapterstiftes 71 mit 73 bezeichnet.

Auf der Oberseite der zweiten Führungsplatte 62 liegt eine sogenannte Folie 74, mit außer Raster angeordneten Löchern 75, deren Durchmesser k der zweifachen Summe aus dem größtmöglichen Versatz 72, 73 und dem Radius der Köpfe 65 entspricht. Die Folie 74 kann also auch nach dem Einführen der Adapterstifte 68 bis 71 nach oben entnommen werden.

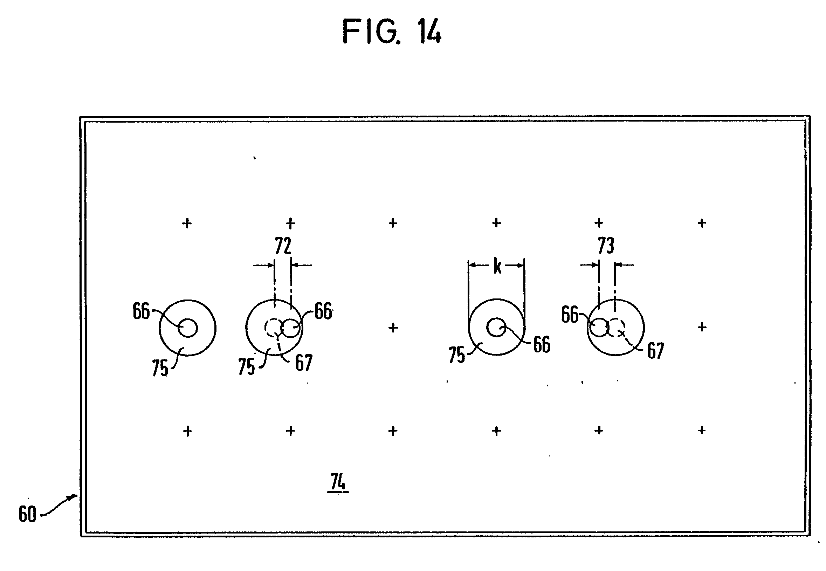

Der Zweck der Folie 74 ist folgender. Zum Laden befindet sich der Adapter 60 in einer Position wie in Figur 13 dargestellt. Die Bedienungsperson blickt folglich von oben auf den Adapter 60 und sieht ihn in einem Bild, wie in Figur 14 dargestellt. Von oben ist natürlich nicht ersichtlich, zu welcher Seite die Führungslöcher 67 in der ersten Führungsplatte 61 gegenüber den Führungslöchern 66 in der zweiten Führungsplatte 62 versetzt sind. Wie Figur 14 deutlich zeigt, läßt sich der Versatz deutlich an der Exzentrizität erkennen, die die Führungslöcher 66 in der zweiten Führungsplatte 62 innerhalb der Löcher 5 in der Folie 74 einnehmen. Die Bedienungsperson kann somit leicht erkennen, zu welcher Seite hin die Führungslöcher 67 in der ersten Führungsplatte 61 hin versetzt sind, und sie vermag die Adapterstifte 68 bis 71 beim Einführen entsprechend schräg zu halten, um die Führungslöcher 67 in der ersten Führungsplatte 61 zu finden.

Dem Adapter 60 kann auch noch eine dritte Führungsplatte 76 zugeordnet sein, die wie die dritte Führungsplatte 16 im ersten Ausführungsbeispiel vertikal verschieblich ist. Mit Hilfe der dritten Führungsplatte 76 kann das Einführen der Adapterstifte 68 bis 71 weiter erleichtert werden, weil diese senkrecht eingeführt werden können, wobei die Adapterstifte 68 bis 71 Führungslöcher 77 in der dritten Führungsplatte 76 durchfassen, und nachdem die Adapterstifte 69, 71 auf der ersten Führungsplatte 61 aufstehen, zur Exzentrizität hin verschwenkt werden, so daß sie in die Führungslöcher 67 eintauchen. Die Führungslöcher 77 in der dritten Führungsplatte 76 befinden sich im Raster.

## Patentansprüche

1. Adapter (13) für ein Leiterplattenprüfgerät, mittels welchem im Raster befindliche Prüfkontakte (8) mit in und/oder außer Raster befindlichen Prüfpunkten einer zu prüfenden Leiterplatte durch Adapterstifte (52-56) verbindbar sind, mit einer ersten Führungsplatte (10), welche mit dem Muster der Prüfpunkte der zu prüfenden Leiterplatte entsprechenden Führungslöchern (18) für die Adapterstifte (52-56) versehen sind, mit einer zweiten Führungsplatte (15), welche zu der ersten Führungsplatte (10) parallel und mit Abstand angeordnet ist und im Raster angeordnete Führungslöcher (19) für die Adapterstifte aufweist, und mit einer dritten Führungsplatte (16), die parallel zwischen der ersten und der zweiten Führungsplatte angeordnet sowie ebenfalls mit Führungslöchern (20) für die Adapterstifte versehen ist, wobei der auf die Prüfpunkte der Leiterplatte aufzusetzende Endbereich (38) der Adapterstifte sich durch die Führungslöcher in der ersten Führungsplatte erstreckt, dadurch gekennzeichnet, daß die dritte Führungsplatte (16) senkrecht zur ersten (10) und der zweiten (15) Führungsplatte verschiebbar ist und die Führungslöcher (20) der dritten Führungsplatte (16) an allen Rasterpunkten vorgesehen sind und einen Durchmesser (f) haben, der ein begrenztes Lenkspiel der Adapterstifte (14) in diesen Führungslöchern (20) zuläßt.

2. Adapter nach Anspruch 1, dadurch gekennzeichnet, daß die dritte Führungsplatte (16) in ihrer oberen Hubendstellung durch eine Haltevorrichtung im bzw. am Adapter (13) fixierbar ist.

3. Adapter nach Anspruch 1 oder 2, dadurch gekennzeichnet, daß die erste Führungsplatte (10) entfernbar bzw. auswechselbar ist.

4. Adapter nach einem der Ansprüche 1 bis 3, dadurch gekennzeichnet, daß die Hubbewegung der dritten Führungsplatte (16) wenigstens in Richtung zur ersten Führungsplatte durch einen Anschlag (23) begrenzt ist.

5. Verfahren zum Laden eines Adapters nach einem der Ansprüche 1 bis 4, dadurch gekennzeichnet, daß der Adapter (13) unter im Raster hängend angeordneten Adapterstiften (14, 51 bis 56) so ausgerichtet wird, daß seine Führungsplatten (10, 15, 16) im wesentlichen horizontal angeordnet sind und daß sich die erste Führungsplatte (10) unten befindet, daß die Adapterstifte (14, 51 bis 56) von oben in die Führungslöcher (19, 20) der zweiten und dritten Führungsplatte (15, 16) eingeführt werden, wobei die Adapterstifte (14, 51 bis 56) gegebenenfalls in im Raster befindliche Führungslöcher (18) der ersten Führungsplatte (10) eintauchen und daß die dritte Führungsplatte (16) aus einer unteren Ausgangsstellung unter Vibration nach oben bewegt wird, wobei Adapterstifte (52, 55 ; Fig. 4), die neben außer Raster befindlichen Führungslöchern (18) auf der ersten Führungsplatte (10) stehen, zu einer wechselnden Auslenkung mit zunehmender Auslenkungsweite (9) veranlaßt werden und in das ihnen zugeordnete nächstliegende, außer Raster befindliche Führungsloch (18) der ersten Führungsplatte (10) eintauchen.

6. Verfahren nach Anspruch 5, dadurch gekennzeichnet, daß die Halterung der Adapterstifte (14, 51 bis 56) nach ihrer teilweisen Einführung in den Adapter (13) aufgehoben wird und die Adapterstifte (14, 51 bis 56) durch ihre Schwerkraft in den Adapter (13), insbesondere in die erste Führungsplatte (10) eingeführt werden.

7. Verfahren nach Anspruch 5 oder 6, dadurch gekennzeichnet, daß nach dem Verschieben der dritten Führungsplatte (16) die Adapterstifte (14, 51 bis 56), die kein Führungsloch (18) in der ersten Führungsplatte (10) gefunden haben, senkrecht ausgerichtet werden.

8. Verfahren nach einem der Ansprüche 5 bis 7, dadurch gekennzeichnet, daß die Adapterstifte (14, 51 bis 56), denen kein Führungsloch (18) in der ersten Führungsplatte (10) zugeordnet ist, wieder aus dem Adapter (13) herausgezogen werden.

9. Verfahren nach einem der Ansprüche 5 bis 8, dadurch gekennzeichnet, daß zum Einführen der Adapterstifte (14, 51 bis 56) bzw. zum Herausziehen der Adapterstifte (53, 56 ; Fig. 7), denen kein Führungsloch (18) in der ersten Führungsplatte (10) zugeordnet ist, der Adapter (13) hoch- bzw. heruntergefahren wird.

10. Verfahren nach einem der Ansprüche 5 bis 9, dadurch gekennzeichnet, daß alle Adapterstifte (14, 51 bis 56) des Adapters (13) gleichzeitig in den Adapter (13) eingeführt werden.

11. Verfahren zum Entladen eines Ladevorgangs nach einem der Ansprüche 5 bis 10 mit Adapterstiften bestückten Adapters, dadurch gekennzeichnet, daß die erste Führungsplatte (10) vom Adapter (13) entfernt wird, daß der Adapter (13) so unter eine Haltevorrichtung (32) für Adapterstifte (14, 51 bis 56), in der sich gegebenenfalls noch die Adapterstifte (53, 56) vom Ladevorgang befinden, denen keine Führungslöcher (18) in der ersten Führungsplatte (10) zugeordnet waren, positioniert wird, daß sich seine Führungsplatten (10, 15, 16) im wesentlichen horizontal erstrecken und die zweite Führungsplatte (15) oben ist, daß der Adapter (13) und die Haltevorrichtung (32) relativ zueinander verschoben werden, wobei die gegebenenfalls in der Haltevorrichtung (32) noch befindlichen Adapterstifte (53, 56) in die unbesetzten Führungslöcher (19, 20) der zweiten und dritten Führungsplatte (15, 16) eintauchen, daß die Haltevorrichtung (32) geöffnet wird und die gegebenenfalls darin befindlichen Adapterstifte (53, 56) freigegeben werden, daß alle Adapterstifte (14, 51 bis 56) des Adapters (13) in ihren Führungslöchern (18, 19, 20) nach oben geschoben werden, daß die Adapterstifte (14, 51 bis 56) ergriffen und festgehalten werden und daß der Adapter (13) und die Adapterstifte (14, 51 bis 56) relativ so zueinander verschoben werden, daß sie außer Eingriff kommen.

12. Verfahren nach Anspruch 11, dadurch gekennzeichnet, daß die Haltevorrichtung (32) beim Verschieben das Adapters (13) nach oben bzw. unten nicht verschoben wird.

13. Vorrichtung zur Durchführung des Verfahrens nach einem der Ansprüche 5 bis 12, gekennzeichnet durch einen Träger (25) für den Adapter (13) und einer Haltevorrichtung (32) für die Adapterstifte (14, 51 bis 56), wobei wenigstens einer dieser beiden Bauteile in Richtung auf den anderen Bauteil verschiebbar und in der jeweiligen Hubstellung gehalten ist, wobei der Vorrichtung (17) ein Vibrator (48) zugeordnet ist, dessen Schwingungen bevorzugt auf die dritte Führungsplatte (16) übertragen werden.

14. Vorrichtung nach Anspruch 13, dadurch gekennzeichnet, daß ihr eine Ausrichtvorrichtung (27) zugeordnet ist, die aus einer sich oberhalb des Adapters (13) erstreckenden Ausrichtplatte (28) mit im Raster angeordneten Führungslöchern (29) für die Adapterstifte (14, 51 bis 56) besteht, die parallel zur Bewegung des Trägers (25) bzw. der Haltevorrichtung (32) verschiebbar und feststellbar ist.

15. Vorrichtung nach Anspruch 13 oder 14, dadurch gekennzeichnet, daß ihr eine Stiftheberplatte (43) zugeordnet ist, die parallel zur Bewegung des Trägers (25) bzw. der Haltevorrichtung (32) verschiebbar und wenigstens in ihren Hubendstellungen feststellbar ist.

16. Vorrichtung nach einem der Ansprüche 13 bis 15, dadurch gekennzeichnet, daß die Haltevorrichtung (32) durch drei übereinanderliegende Klemmplatten (33, 34) gebildet ist, die in ihrer Offenstellung im Raster angeordnete Löcher (35) zur Aufnahme der Adapterstifte (14, 51 bis 56) aufweisen, wobei die Löcher (35) geringfügig größer bemessen sind, als die Köpfe (37) der Adapterstifte und sowohl der oberen und unteren Klemmplatte (33) als auch der mittleren Klemmplatte (34) ein Zylinder-Kolbenantrieb (41, 42) zu ihrer Verschiebung in der Plattenebene zugeordnet ist.

17. Vorrichtung nach einem der Ansprüche 13 bis 16, dadurch gekennzeichnet, daß zum Verschieben des Trägers (25) bzw. der Haltevorrichtung (32) der dritten Führungsplatte (16), der Ausrichtvorrichtung (27), der Stiftheberplatte (43) und der Klemmplatten (33, 34) Zylinder-Kolbenantriebe (24, 26, 31, 41, 42, 44) vorgesehen sind.

18. Vorrichtung nach Anspruch 17, dadurch gekennzeichnet, daß die Zylinder-Kolbenantriebe an eine Druckluftquelle (47) und eine bevorzugt automatisch arbeitende Steuereinheit (46) angeschlossen sind.

19. Adapter für ein Leiterplattenprüfgerät, mittels welchem im Raster befindliche Prüfkontakte (7) mit in und/oder außer Raster befindlichen Prüfpunkten einer zu prüfenden Leiterplatte durch Adapterstifte (14, 64, 68-71) verbindbar sind, mit einer ersten Führungsplatte (10, 61), welche mit dem Muster der Prüfpunkte der zu prüfenden Leiterplatte entsprechenden Führungslöchern für die Adapterstifte versehen ist, und mit einer zweiten Führungsplatte (15, 62), welche zu der ersten Führungsplatte parallel und mit Abstand angeordnet ist und im Raster angeordnete Führungslöcher für die Adapterstifte aufweist, wobei der auf die Prüfpunkte der Leiterplatte aufzusetzende Endbereich der Adapterstifte sich durch die Führungslöcher in der ersten Führungsplatte erstreckt, dadurch gekennzeichnet, daß die Adapterstifte (14, 64, 68-71) an ihrem mit den Prüfkontakten (7) zu verbindenden Ende eine Verdickung (65) aufweisen, die einen größeren Durchmesser als die Führungslöcher in der zweiten Führungsplatte (62) haben.

20. Adapter nach Anspruch 19, dadurch gekennzeichnet, daß sich die zweite Führungsplatte (15, 62) sowohl beim Laden mit den Adapterstiften (14, 64) als auch beim Prüfen im Leiterplattenprüfgerät oben befindet, derart, daß die Adapterstifte (14, 64) in der zweiten Führungsplatte (15, 62) hängen.

21. Adapter nach Anspruch 19 oder 20, mit einer zwischen der ersten Führungsplatte und der zweiten Führungsplatte parallel zu diesen angeordneten dritten Führungsplatte, die ebenfalls mit Führungslöchern für die Adapterstifte versehen ist, dadurch gekennzeichnet, daß die Führungslöcher (20, 77) der dritten Führungsplatte (16, 76) an allen Rasterpunkten vorgesehen sind und einen Durchmesser (f) haben, der ein begrenztes Spiel der Adapterstifte (14, 64) in diesen Löchern (20, 77) zuläßt.

22. Adapter nach Anspruch 21, dadurch gekennzeichnet, daß die dritte Führungsplatte (16, 76) senkrecht zur ersten und der zweiten Führungsplatte (10, 15 ; 61, 62) verschiebbar ist.

23. Verfahren zum Laden eines Adapters nach einem der Ansprüche 19 bis 22 mit Adapterstiften, dadurch gekennzeichnet, daß auf die oben befindliche zweite Führungsplatte (62) eine Folie (74) aufgelegt wird, die ebenso wie die erste Führungsplatte (61) mit Löchern (75) versehen ist, die im Muster der Prüfpunkte der zu prüfenden Leiterplatte angeordnet sind, wobei die Löcher (75) der Folie (74) einen Durchmesser (k) haben, der größer als der Durchmesser der Verdickungen (65) an den Adapterstiften (64) ist, daß die Adapterstifte (64) dann durch die Löcher (75) in der Folie (74) und die unterhalb dieser Löcher (75) befindlichen Führungslöcher (67) in der zweiten Führungsplatte (66) so eingeführt werden, daß sie in die konzentrisch zu den Löchern (75) in der Folie (74) liegenden Führungslöchern (66) der ersten Führungsplatte (61) treffen, und daß die Folie (74) dann von der zweiten Führungsplatte (62) entfernt wird.

**Claims**

1. Adapter (13) for a printed circuit board testing device, by means of which test contacts (8), which are found in the grid, may be connected with test points, which are found in and/or beyond (off) the grid, of a printed circuit board which is to be tested, by means of adapter pins (52-56), having a first guide plate (10) provided with guide holes (18) for the adapter pins (52-56), which holes correspond to the pattern of the test points of the printed circuit board which is to be tested, having a second guide plate (15) which is arranged at a distance from and parallel to the first guide plate and which has guide holes (19) for the adapter pins, which holes are arranged in the grid, and having a third guide plate (16) which is arranged parallel to and between the first and the second guide plates and which is also provided with guide holes (20) for the adapter pins, wherein the end region (38) of the adapter pins which is to be superimposed on the test points of the printed circuit board extends through the guide holes in the first guide plate, characterised in that the third guide plate (16) may be shifted at right angles to the first (10) and to the second (15) guide plates and the guide holes (20) of the third guide plate (16) are provided at all of the points of the grid and have a diameter (f) which tolerates a limited amount of clearance for steering of the adapter pins (14) in these guide holes (20).

2. Adapter according to claim 1, characterised in that the third guide plate (16) may be fixed in its upper end of lift position by means of a holding device in or on the adapter (13).

3. Adapter according to claim 1 or claim 2, characterised in that the first guide plate (10) may be removed or replaced.

4. Adapter according to any one of claims 1 to 3, characterised in that the lifting movement of the third guide plate (16) is restricted, at least in the direction towards the first guide plate, by means of a stop (23).

5. Method for loading an adapter according to any one of claims 1 to 4, characterised in that the adapter (13) is aligned underneath adapter pins (14, 51 to 56), which are arranged suspended in the grid, in such a way that its guide plates (10, 15, 16) are arranged in an essentially horizontal manner and the first guide plate (10) is found at the bottom, in that the adapter pins (14, 51 to 56) are inserted from above into the guide holes (19, 20) of the second and third guide plate (15, 16), in which case the adapter pins (14, 51 to 56) dip, if necessary, into guide holes (18), which are found in the grid, of the first guide plate (10) and in that the third guide plate (16) is moved upwards out of a lower starting position through vibration, in which case adapter pins (52, 55 ; Fig. 4), which stand by the side of guide holes (18), which are found beyond (off) the grid, on the first guide plate (10), are induced to deflect in a varying manner with an increasing width of deflection (9) and dip into the associated guide hole (18) of the first guide plate (10), which is nearest to them and is found beyond (off) the grid.

6. Method according to claim 5, characterised in that the mounting support of the adapter pins (14, 51 to 56) is raised after the partial insertion of the pins into the adapter (13), more particularly into the first guide plate (10), through their gravitational force.

7. Method according to claim 5 or claim 6, characterised in that after the third guide plate (16) has shifted, the adapter pins (14, 51 to 56), which have not found a guide hole (18) in the first guide plate (10), are aligned so that they are perpendicular.

8. Method according to any one of claims 5 to 7, characterised in that the adapter pins (14, 51 to 56) to which no guide hole (18) is assigned in the first guide plate (10) are drawn back out of the adapter (13).

9. Method according to any one of claims 5 to 8, characterised in that for the purpose of inserting the adapter pins (14, 51 to 56) or of drawing out the adapter pins (53, 56 ; Fig. 7) to which no guide hole (18) is assigned in the first guide plate (10) the adapter (13) is moved upwards or downwards.

10. Method according to any one of claims 5 to 9, characterised in that all the adapter pins (14, 51 to 56) of the adapter (13) are inserted into the adapter (13) at the same time.

11. Method for unloading an adapter fitted with adapter pins according to any one of claims 5 to 10, characterised in that the first guide plate (10) is removed from the adapter (13), in that the adapter (13) is positioned underneath a holding device (32) for adapter pins (14, 51 to 56), in which the adapter pins (53, 56) from the loading process to which no guide holes (18) were assigned in the first guide plate (10) may still be found, in such a way that its guide plates (10, 15, 16) extend in an essentially horizontal manner and the second guide plate (15) is at the top, in that the adapter (13) and the holding device (32) are shifted relative to each other, in which case the adapter pins (53, 56) which may still be found in the holding device (32) dip into the unoccupied guide holes (19, 20) of the second and third guide plates (15, 16), in that the holding device (32) is opened and the adapter pins (53, 56) which may be found therein are released, in that all the adapter pins (14, 51 to 56) of the adapter (13) are pushed upwards in their guide holes (18, 19, 20), in that the adapter pins (14, 51 to 56) are gripped and held fast and in that the adapter (13) and the adapter pins (14, 51 to 56) are shifted relative to each other in such a way that they become disengaged.

12. Method according to claim 11, characterised in that when the adapter is shifted upwards or downwards the holding device (32) is not shifted.

13. Apparatus for carrying out the method according to any one of claims 5 to 12, characterised by a support (25) for the adapter (13) and a holding device (32) for the adapter pins (14, 51 to 56) wherein at least one of these two component parts may be shifted in the direction of the other component part and held in the respective lifting position, and wherein a vibrator (48), the vibrations of which are preferably transmitted to the third guide plate (16), is associated with the apparatus (17).

14. Apparatus according to claim 13, characterised in that there is associated therewith an aligning apparatus (27) which consists of an aligning plate (28), which extends above the adapter (13), which has guide holes (29) for the adapter pins (14, 51 to 56) which are arranged in the grid and which may be shifted parallel to the movement of the support (25) or of the holding device (32) and which may be fixed.

15. Apparatus according to claim 13 or claim 14, characterised in that there is associated therewith a pin-lifting plate (43) which may be shifted parallel to the movement of the support (25) or of the holding device (32) and which may be fixed at least in its end of lift positions.

16. Apparatus according to any one of claims 13 to 15, characterised in that the holding device (32) is formed by means of three clamping plates (33, 34), which lie one upon the other and which have in their opening positions holes (35), which are arranged in the grid, for the purpose of receiving the adapter pins (14, 51 to 56), in which case the holes (35) are dimensioned so that they are slightly larger than the heads (37) of the adapter pins and a cylinder-piston drive (41, 42) is associated not only with the upper and lower clamping plate (33), but also with the middle clamping plate (34) for the purpose of shifting them in the plate plane.

17. Apparatus according to any one of claims 13 to 16, characterised in that cylinder-piston drives (24, 26, 31, 41, 42, 44) are provided for the purpose of shifting the support (25) or the holding device (32), the third guide plate (16), the aligning apparatus (27), the pin-lifting plate (43) and the clamping plates (33, 34).

18. Apparatus according to claim 17, characterised in that the cylinder-piston drives are connected to a compressed-air source (47) and a control unit (46) which preferably operates automatically.

19. Adapter for a printed circuit board testing device, by means of which test contacts (7) which are found in the grid may be connected with test points which are found in and/or beyond (off) the grid of a printed circuit board which is to be tested by means of adapter pins (14, 64, 68-71), having a first guide plate (10, 61) which is provided with guide holes for the adapter pins, which holes correspond to the pattern of the test points of the printed circuit board which is to be tested, and having a second guide plate (15, 62) which is arranged at a distance from and parallel to the first guide plate and which has guide holes for the adapter pins, which holes are arranged in the grid, wherein the end region of the adapter pins, which is to be superimposed on the test points of the printed circuit board, extends through the guide holes in the first guide plate, characterised in that the adapter pins (14, 64, 68-67) have at their end which is to be connected with the test contacts (7) a thickened area (65) having a greater diameter than the guide holes' in the second guide plate (62).

20. Adapter according to claim 19, characterised in that the second guide plate (15, 62) is located at the top not only when loading with the adapter pins (14, 64), but also when testing in the printed circuit board testing device, in such a way that the adapter pins (14, 64) are suspended in the second guide plate (15, 62).

21. Adapter according to claim 19 or claim 20 having a third guide plate which is arranged between and parallel to the first guide plate and the second guide plate and which is also provided with guide holes for the adapter pins, characterised in that the guide holes (20, 77) of the third guide plate (16, 76) are provided at all points of the grid and have a diameter (f) which tolerates a limited amount of free motion of the adapter pins (14, 64) in these holes (20, 77).

22. Adapter according to claim 21, characterised in that the third guide plate (16, 76) may be shifted at right angles to the first and to the second guide plate (10, 15 ; 61, 62).

23. Method for loading an adapter according to any one of claims 19 to 22 with adapter pins, characterised in that a foil (74), which like the first guide plate (61) is also provided with holes (75) which are arranged in the pattern of the test points of the printed circuit board which is to be tested, is applied to the second guide plate (62) which is located at the top, the holes (75) of the foil (74) having a diameter (k) which is greater than the diameter of the thickened areas (65) on the adapter pins (64), in that the adapter pins (64) are then inserted through the holes (75) in the foil (74) and the guide holes (67) which are found in the second guide plate (66) below these holes (75), in such a way that they run into the guide holes (66) of the first guide plate (61), which guide holes lie so that they are concentric in respect of the holes (75) in the foil (74), and in that the foil (74) is then removed from the second guide plate (62).

**Revendications**

1. Adaptateur (13) pour appareil de contrôle de cartes imprimées, au moyen duquel des contacts de test (8) disposés suivant une grille peuvent être reliés par des aiguilles d'adaptation (52-56) à des points de test d'une carte imprimée à contrôler qui sont situés suivant et/ou en dehors de la grille, cet adaptateur comportant une première plaque de guidage (10) qui présente des trous (18) de guidage des aiguilles d'adaptation (52-56), ces trous correspondant au motif des points de test de la carte imprimée à contrôler, une deuxième plaque de guidage (15) qui est parallèle à la première plaque de guidage (10), en étant espacée de celle-ci, et présente des trous (19) de guidage des aiguilles d'adaptation, ces trous étant disposés suivant la grille, et une troisième plaque de guidage (16) qui est disposée parallèlement entre les première et deuxième plaques de guidage et qui présente également des trous (20) de guidage des aiguilles d'adaptation, les parties extrêmes (38) des aiguilles d'adaptation qui doivent s'appliquer sur les points de test s'étendant à travers les trous de la première plaque de guidage, caractérisé en ce que la troisième plaque de guidage (16) est déplaçable en translation perpendiculairement à la première plaque de guidage (10) et à la seconde plaque de guidage (15) et les trous de guidage (20) de la troisième plaque de guidage (16) sont prévus en tous les points de la grille et possèdent un diamètre (f) qui autorise un débattement angulaire limité des aiguilles d'adaptation (14) dans ces trous de guidage (20).

2. Adaptateur suivant la revendication 1, caractérisé en ce que, dans sa position extrême supérieure de levée, la troisième plaque de guidage (16) peut être immobilisée dans ou sur l'adaptateur (13) au moyen d'un dispositif de maintien.

3. Adaptateur suivant la revendication 1 ou 2, caractérisé en ce que la première plaque de guidage (10) est amovible ou interchangeable.

4. Adaptateur suivant l'une des revendications 1 à 3, caractérisé en ce que le déplacement de levée de la troisième plaque de guidage (16) est limité, au moins en direction de la première plaque de guidage, par une butée (23).

5. Procédé de chargement d'un adaptateur suivant l'une des revendications 1 à 4, caractérisé en ce qu'on oriente l'adaptateur (13), les aiguilles d'adaptation (14, 51 à 56) étant suspendues suivant la grille, de façon telle que ses plaques de guidage (10, 15, 16) soient disposées de manière essentiellement horizontale et que la première plaque de guidage (10) se trouve en dessous, en ce qu'on introduit les aiguilles d'adaptation (14, 51 à 56) par en haut dans les trous de guidage (19, 20) des deuxième et troisième plaques de guidage (15, 16), ces aiguilles d'adaptation (14, 51 à 56) s'enfonçant éventuellement dans des trous de guidage (18) de la première plaque de guidage (10) qui sont disposés suivant la grille, et en ce que, tout en la soumettant à des vibrations, on déplace la troisième plaque de guidage (16) vers le haut à partir d'une position inférieure initiale, de sorte que des aiguilles d'adaptation (52, 55 ; Fig. 4) qui reposent sur la première plaque de guidage (10) à côté de trous de guidage (18) disposés en dehors de la grille sont astreintes à prendre une inclinaison à variation alternative et à amplitude (g) croissante et s'enfoncent dans le trou de guidage (18) de la première plaque de guidage (10), se trouvant en dehors de la grille, qui en est le plus proche.

6. Procédé suivant la revendication 5, caractérisé en ce qu'après l'introduction partielle des aiguilles d'adaptation (14, 51 à 56) dans l'adaptateur (13), on soulève le support de ces aiguilles et celles-ci s'introduisent, sous l'effet de leur poids, dans l'adaptateur (13), notamment dans la première plaque de guidage (10).

7. Procédé suivant la revendication 5 ou 6, caractérisé en ce qu'après le déplacement en translation de la troisième plaque de guidage (16), les aiguilles d'adaptation (14, 51 à 56) qui n'ont pas rencontré de trou de guidage (18) dans la première plaque de guidage (10) s'orientent verticalement.

8. Procédé suivant l'une des revendications 5 à 7, caractérisé en ce qu'on retire à nouveau de l'adaptateur (13) les aiguilles d'adaptation (14, 51 à 56) auxquelles aucun trou de guidage (18) n'est associé dans la première plaque de guidage (10).

9. Procédé suivant l'une des revendications 5 à 8, caractérisé en ce qu'en vue de l'introduction des aiguilles d'adaptation (14, 51 à 56) ou en vue de l'extraction des aiguilles d'adaptation (53, 56 ; Fig. 7) auxquelles aucun trou de guidage (18) n'est associé dans la première plaque de guidage (10), on déplace l'adaptateur (13) vers le haut ou vers le bas.

10. Procédé suivant l'une des revendications 5 à 9, caractérisé en ce qu'on introduit simultanément dans l'adaptateur (13) toutes les aiguilles d'adaptation (14, 51 à 56) de cet adaptateur (13).

11. Procédé de déchargement d'un adaptateur muni d'aiguilles d'adaptation à la suite d'une opération de chargement suivant l'une des revendications 5 à 10, caractérisé en ce qu'on retire de l'adaptateur (13) la première plaque de guidage (10), en ce qu'on place l'adaptateur (13) au-dessous d'un dispositif (32) de maintien des aiguilles d'adaptation (14, 51 à 56) dans lequel se trouvent éventuellement encore les aiguilles d'adaptation (53, 56), provenant de l'opération de chargement, auxquelles aucun trou de guidage (18) n'est associé dans la première plaque de guidage (10), cette mise en place de l'adaptateur s'effectuant de façon telle que ses plaques de guidage (10, 15, 16) s'étendent d'une manière essentiellement horizontale et que la deuxième plaque de guidage (15) soit en dessus, en ce qu'on déplace en translation relative l'un par rapport à l'autre l'adaptateur (13) et le dispositif de maintien (32), de sorte que les aiguilles d'adaptation (53, 56) se trouvant éventuellement encore dans le dispositif de maintien (32) s'enfoncent dans les trous de guidage (19, 20), non occupés, des deuxième et troisième plaques de guidage (15, 16), en ce qu'on fait s'ouvrir le dispositif de maintien (32), ce qui libère les aiguilles d'adaptation (53, 56) qui s'y trouvent éventuellement, en ce qu'on déplace vers le haut toutes les aiguilles d'adaptation (14, 51 à 56) de l'adaptateur (13) dans leurs trous de guidage (18, 19, 20), en ce qu'on saisit et maintient ces aiguilles d'adaptation (14, 51 à 56) et en ce qu'on déplace en translation relative entre eux l'adaptateur (13) et les aiguilles d'adaptation (14, 51 à 56), de façon telle qu'ils viennent hors de prise entre eux.

12. Procédé suivant la revendication 11, caractérisé en ce que, dans le cas d'un déplacement en translation de l'adaptateur vers le haut ou vers le bas, on ne déplace pas en translation le dispositif de maintien (32).

13. Dispositif de mise en oeuvre du procédé suivant l'une des revendications 5 à 12, caractérisé en ce qu'il comprend un support (25) pour l'adaptateur (13) et un dispositif de maintien (32) pour les aiguilles d'adaptation (14, 51 à 56), au moins l'un de ces deux éléments structurels pouvant être déplacé en translation en direction de l'autre et étant maintenu dans chaque position de levée, tandis qu'il est associé au dispositif (17) un vibrateur (48) dont les oscillations sont de préférence transmises à la troisième plaque de guidage (16).

14. Dispositif suivant la revendication 13, caractérisé en ce qu'il lui est associé un dispositif d'orientation (27) qui est constitué d'une plaque d'orientation (28) s'étendant au-dessus de l'adaptateur (13) et présentant des trous (29), de guidage des aiguilles d'adaptation (14, 51 à 56), disposés suivant la grille, cette plaque d'orientation pouvant être déplacée, et immobilisée, parallèlement au déplacement du support (25) ou du dispositif de maintien (32).

15. Dispositif suivant la revendication 13 ou 14, caractérisé en ce qu'il lui est associé une plaque de levée d'aiguilles (43) qui peut être déplacée, et immobilisée, au moins dans ses positions extrêmes de levée, parallèlement au déplacement du support (25) ou du dispositif de maintien (32).

16. Dispositif suivant l'une des revendications 13 à 15, caractérisé en ce que le dispositif de maintien (32) est constitué de trois plaques de serrage (33, 34) disposées l'une au-dessus de l'autre et comprenant des trous (35) qui sont disposés suivant la grille dans leur position ouverte et servent à recevoir les aiguilles d'adaptation (14, 51 à 56), la dimension de ces trous (35) étant légèrement plus grande que les têtes (37) des aiguilles d'adaptation, tandis qu'une commande par vérin (41, 42) est associée d'une part aux plaques supérieure et inférieure de serrage (33) et d'autre part à la plaque centrale de serrage (34), en vue de leur déplacement en translation dans le plan des plaques.

17. Dispositif suivant l'une des revendications 13 à 16, caractérisé en ce que des commandes par vérin (24, 26, 31, 41, 42, 44) sont prévues pour le déplacement en translation du support (25) ou du dispositif de maintien (32), de la troisième plaque de guidage (16), du dispositif d'orientation (27), de la plaque de levée d'aiguilles (43) et des plaques de serrage (33, 34).

18. Dispositif suivant la revendication 17, caractérisé en ce que les commandes par vérin sont raccordées à une source d'air comprimé (47) et à une unité de commande (46) de préférence automatique.

19. Adaptateur pour appareil de contrôle de cartes imprimées, au moyen duquel des contacts de test (7) disposés suivant une grille peuvent être reliés par des aiguilles d'adaptation (14, 64, 68-71) à des points de test d'une carte imprimée à contrôler qui sont situés suivant et/ou en dehors de la grille, cet adaptateur comportant une première plaque de guidage (10, 61) qui présente des trous de guidage des aiguilles d'adaptation, ces trous correspondant au motif des points de test de la carte imprimée à contrôler, et une deuxième plaque de guidage (15, 62) qui est parallèle à la première plaque de guidage, en étant espacée de celle-ci, et présente des trous de guidage des aiguilles d'adaptation, ces trous étant disposés suivant la grille, les parties extrêmes des aiguilles d'adaptation qui doivent s'appliquer sur les points de test s'étendant à travers les trous de guidage de la première plaque, caractérisé en ce qu'à leurs extrémités à relier aux contacts de test (7), les aiguilles d'adaptation (14, 64, 68-71) présentent une partie plus épaisse (65) qui possède un diamètre plus grand que les trous de guidage de la deuxième plaque (62).

20. Adaptateur suivant la revendication 19, caractérisé en ce qu'aussi bien lors du chargement avec des aiguilles d'adaptation (14, 64) que lors du contrôle dans l'appareil de contrôle de cartes imprimées, la deuxième plaque de guidage (15, 62) est située en dessus, de façon telle que les aiguilles d'adaptation (14, 64) sont suspendues dans cette deuxième plaque de guidage (15, 62).

21. Adaptateur suivant la revendication 19 ou 20, comprenant une troisième plaque de guidage, située entre la première plaque de guidage et la deuxième plaque de guidage et parallèle à celles-ci, qui est également pourvue de trous de guidage pour les aiguilles d'adaptation, caractérisé en ce que les trous de guidage (20, 77) de la troisième plaque de guidage (16, 76) sont prévus en tous les points de la grille et possèdent un diamètre (f) qui autorise un débattement limité des aiguilles d'adaptation (14, 64) dans ces trous (20, 77).

22. Adaptateur suivant la revendication 21, caractérisé en ce que la troisième plaque de guidage (16, 76) est déplaçable en translation perpendiculairement aux première et deuxième plaques de guidage (10, 15 ; 61, 62).

23. Procédé de chargement d'un adaptateur suivant l'une des revendications 19 à 22 en aiguilles d'adaptation, caractérisé en ce que, sur la deuxième plaque de guidage (62) qui se trouve sur le dessus, on pose une feuille (74) qui, à l'instar de la première plaque de guidage (61), présente des trous (75) qui sont disposés suivant la grille des points de test de la carte imprimée à contrôler, les trous (75) de cette feuille (74) possédant un diamètre (k) qui est supérieur au diamètre des parties plus épaisses (65) des aiguilles d'adaptation (64), en ce qu'on introduit alors ces aiguilles d'adaptation (64) dans les trous (75) de la feuille (74) et dans les trous de guidage (67) de la deuxième plaque de guidage (66) qui se trouvent au-dessous de ces trous (75), de façon telle qu'elles se trouvent situées dans les trous de guidage (66) de la première plaque de guidage (61) qui sont disposés de manière concentrique aux trous (75) de la feuille (74), et en ce qu'on retire alors cette feuille (74) de la deuxième plaque de guidage (62).

EP 0 144 682 B1

FIG. 1

FIG. 12

FIG. 2

EP 0 144 682 B1

FIG. 3

FIG. 4

EP 0 144 682 B1

FIG. 5

EP 0 144 682 B1

FIG. 6

EP 0 144 682 B1

FIG. 7

EP 0 144 682 B1

FIG. 8

EP 0 144 682 B1

FIG. 9

EP 0 144 682 B1

FIG. 10

29  37  37  33  34

51  52  53  54  55  56

43

44  44

EP 0 144 682 B1

10

FIG. 11.

FIG. 13

EP 0 144 682 B1

FIG. 14